(19) Europäisches Patentamt
European Patent Office
Office européen des brevets

(11) **EP 3 503 246 A1**

(12) **EUROPEAN PATENT APPLICATION**
published in accordance with Art. 153(4) EPC

(43) Date of publication:
**26.06.2019 Bulletin 2019/26**

(51) Int Cl.:
***H01M 2/10*** *(2006.01)*          ***G01R 31/36*** *(2019.01)*

(21) Application number: **17841247.4**

(22) Date of filing: **21.03.2017**

(86) International application number:
**PCT/JP2017/011176**

(87) International publication number:
**WO 2018/034019 (22.02.2018 Gazette 2018/08)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **19.08.2016 JP 2016161066**

(71) Applicant: TOYO TIRE CORPORATION
Itami-shi,
Hyogo 6640847 (JP)

(72) Inventors:
• **FUKUDA,Takeshi**
**Itami-shi**
**Hyogo 664-0847 (JP)**
• **SUZUKI,Aya**
**Itami-shi**
**Hyogo 664-0847 (JP)**

(74) Representative: **Sajda, Wolf E.**
**Meissner Bolte Patentanwälte**
**Rechtsanwälte Partnerschaft mbB**
**Postfach 86 06 24**
**81633 München (DE)**

(54) **ASSEMBLED BATTERY MANUFACTURING METHOD USING USED BATTERIES, AND ASSEMBLED BATTERY**

(57) According to the present invention, the residual capacity of a battery in a fully-charged state is measured for each of a plurality of batteries (A, B, C) which become candidates to constitute a serial body (step S11). Then, the batteries (A, B) to constitute the serial body are selected from among the candidate batteries (A, B, C) on the basis of the residual capacities (step S12). Here, only the batteries (A, B), wherein the absolute value of the difference between the residual capacity and the maximum residual capacity of each battery is within 10 % of the maximum residual capacity, are selected from among the batteries constituting the serial body. Then, the serial body is formed by connecting only the selected batteries (A, B) in series (step S13).

FIG. 5

```
        ┌─────────────────────────────┐
        │   ASSEMBLED BATTERY          │
        │   MANUFACTURING METHOD       │
        └─────────────────────────────┘
                      │
                      ▼
   ┌──────────────────────────────────────────┐
   │ MEASURE RESIDUAL CAPACITY IN FULLY CHARGED │──── S11
   │ STATE FOR EACH OF A PLURALITY OF BATTERIES │
   │ WHICH ARE CANDIDATE BATTERIES TO           │
   │ CONSTITUTE SERIAL BODY                     │
   └──────────────────────────────────────────┘
                      │
                      ▼
   ┌──────────────────────────────────────────┐
   │ SELECT BATTERIES (A, B) CONSTITUTING       │──── S12
   │ SERIAL BODY FROM AMONG A PLURALITY OF      │
   │ CANDIDATE BATTERIES (A, B, C) ON BASIS OF  │
   │ RESIDUAL CAPACITIES, AND HERE, SELECT ONLY │
   │ BATTERIES (A, B) WHEREIN ABSOLUTE VALUE OF │
   │ DIFFERENCE BETWEEN RESIDUAL CAPACITY OF    │
   │ EACH BATTERY AND MAXIMUM RESIDUAL CAPACITY │
   │ AMONG BATTERIES CONSTITUTING SERIAL BODY   │
   │ IS WITHIN 10% OF MAXIMUM RESIDUAL CAPACITY │
   └──────────────────────────────────────────┘
                      │
                      ▼
   ┌──────────────────────────────────────────┐
   │ FORM SERIAL BODY BY ONLY CONNECTING        │──── S13
   │ SELECTED BATTERIES (A, B) IN SERIES        │
   └──────────────────────────────────────────┘
                      │
                      ▼
                 ┌─────────┐
                 │   END   │
                 └─────────┘
```

EP 3 503 246 A1

**Description**

<u>TECHNICAL FIELD</u>

The present invention relates to an assembled battery manufacturing method using used batteries, and an assembled battery.

<u>BACKGROUND ART</u>

In recent years, sealed secondary batteries represented by lithium ion secondary batteries (which may hereafter be simply referred to as "secondary batteries") are used not only in mobile devices such as portable phones and notebook-type personal computers but also as a power source for electric vehicles such as electric automobiles and hybrid automobiles. For use in electric vehicles, an assembled battery constituted by connection of a plurality of secondary batteries is used. Even when the vehicles are discarded, the mounted assembled battery may still be in a usable state.

Also, when the assembled battery is replaced due to inconvenience of some of the secondary batteries constituting the assembled battery, the secondary batteries other than those in inconvenience may still be in a usable state. In this manner, it was proposed that the secondary batteries collected after being used (which may hereafter be referred to as used batteries) are recycled for use without being discarded.

In the numerous used batteries that have been collected, batteries that were used in various types of environments are mixedly present, so that the degree of deterioration of the batteries may differ battery by battery. For this reason, depending on the method of combining and assembling the batteries, the deterioration may be considerably promoted as compared with the case in which new batteries are combined with each other and assembled. Patent Documents 1 and 2 may be mentioned as examples of the documents that refer to recycling of the batteries.

Patent Document 1 describes measuring an internal resistance of a battery and discarding the batteries having an internal resistance larger than or equal to a threshold value. However, it is difficult to select batteries by only making reference to the internal resistance. There may be cases in which, even when the internal resistance is low, the deterioration is promoted depending on the method of connecting the batteries.

Patent Document 2 describes discarding a battery when the capacity of the battery is lower than a discard threshold value. However, it seems that there may be cases in which, even when the capacity is low, the battery is usable by suppressing deterioration depending on the method of connecting the battery.

<u>PRIOR ART DOCUMENTS</u>

<u>PATENT DOCUMENTS</u>

Patent Document 1: JP 2015-103 387 A
Patent Document 2: JP 2005-238 969 A

<u>SUMMARY OF THE INVENTION</u>

<u>PROBLEMS TO BE SOLVED BY THE INVENTION</u>

The present invention has been made in view of such circumstances, and an object thereof is to provide an assembled battery manufacturing method using used batteries and an assembled battery that are capable of suppressing deterioration.

<u>MEANS FOR SOLVING THE PROBLEMS</u>

To solve the foregoing problem, the present invention employs means as described below.

According to the present invention, there is provided an assembled battery manufacturing method using used batteries, wherein the assembled battery includes a serial body constituted by series connection of a plurality of batteries, the assembled battery manufacturing method comprising:

a step of measuring a residual capacity in a fully charged state for each of a plurality of batteries which are candidate batteries to constitute the serial body;
a step of selecting batteries constituting the serial body from among the plurality of candidate batteries on a basis of the residual capacities; and
a step of forming the serial body by only connecting the selected batteries in series,
wherein the step of selecting the batteries includes selecting only the batteries wherein an absolute value of difference between the residual capacity of each battery and a maximum residual capacity among the batteries constituting the serial body is within 10 % of the maximum residual capacity.

By performing this process, a situation in which the battery having a small residual capacity is overcharged and overly discharged to promote the deterioration can be avoided, so that an assembled battery can be manufactured in which the deterioration is not promoted even when the used batteries are used.

According to the present invention, there is provided an assembled battery manufacturing method using used batteries, wherein the assembled battery includes a parallel body constituted by parallel connection of a plurality of batteries, the assembled battery manufacturing method comprising:

a step of measuring an internal resistance and a remaining active material amount for each of a plurality of batteries which are candidate batteries to constitute the parallel body;
a step of calculating an evaluation value which is obtained by dividing a reciprocal of a value of the internal resistance by the remaining active material amount;
a step of selecting batteries constituting the parallel body from among the plurality of candidate batteries on a basis of the evaluation values; and
a step of forming the parallel body by only connecting the selected batteries in parallel, wherein the step of selecting the batteries includes selecting only the batteries wherein an absolute value of difference between the evaluation value of each battery and a maximum evaluation value among the batteries constituting the parallel body is within 10 % of the maximum evaluation value.

By performing this process, a situation in which the electric current amount per active material of the battery having a small internal resistance increases to promote the deterioration can be avoided, so that an assembled battery can be manufactured in which the deterioration is not promoted even when the used batteries are used.

According to the present invention, there is provided an assembled battery manufacturing method using used batteries, wherein the assembled battery includes a serial body constituted by series connection of a plurality of parallel bodies, each of the parallel bodies being constituted by parallel connection of a plurality of batteries, the assembled battery manufacturing method comprising: a step of measuring a residual capacity in a fully charged state, an internal resistance, and a remaining active material amount for each of a plurality of batteries which are candidate batteries to constitute the assembled battery; a step of calculating an evaluation value which is obtained by dividing a reciprocal of a value of the internal resistance by the remaining active material amount; a step of selecting batteries constituting each of the parallel bodies from among the plurality of candidate batteries on a basis of the evaluation values, and forming each of the parallel bodies by only connecting the selected batteries in parallel; and a step of selecting parallel bodies constituting the serial body from among the plurality of parallel bodies on a basis of the residual capacities, and forming the serial body by only connecting the selected parallel bodies in series, wherein the step of selecting the batteries constituting each of the parallel bodies includes selecting only the batteries wherein an absolute value of difference between the evaluation value of each battery and a maximum evaluation value among the batteries constituting each of the parallel bodies is within 10 % of the maximum evaluation value, and the step of selecting the parallel bodies constituting the serial body includes selecting only the parallel bodies wherein an absolute value of difference between the residual capacity of each parallel body and a maximum residual capacity among the parallel bodies constituting the serial body is within 10 % of the maximum residual capacity.

By performing this process, a situation in which the electric current amount per active material of the battery having a small internal resistance increases to promote the deterioration can be avoided, and also a situation in which the battery having a small residual capacity is overcharged and overly discharged to promote the deterioration can be avoided, so that an assembled battery can be manufactured in which the deterioration is not promoted even when the used batteries are used.

According to the present invention, there is provided an assembled battery using used batteries, wherein the assembled battery comprises a serial body constituted by series connection of a plurality of batteries, and an absolute value of difference between a residual capacity in a fully charged state of each battery constituting the serial body and a maximum residual capacity among the batteries constituting the serial body is within 10 % of the maximum residual capacity.

With this construction, a situation in which the battery having a small residual capacity is overcharged and overly discharged to promote the deterioration can be avoided, so that an assembled battery can be provided in which the deterioration is not promoted even when the used batteries are used.

According to the present invention, there is provided an assembled battery using used batteries, wherein the assembled battery comprises a parallel body constituted by parallel connection of a plurality of batteries, and an absolute value of difference between an evaluation value, which is obtained by dividing a reciprocal of an internal resistance value by a remaining active material amount, of each battery constituting the parallel body and a maximum evaluation value among the batteries constituting the parallel body is within 10 % of the maximum evaluation value.

With this construction, a situation in which the electric current amount per active material of the battery having a small internal resistance increases to promote the deterioration can be avoided, so that an assembled battery can be provided in which the deterioration is not promoted even when the used batteries are used.

According to the present invention, there is provided an assembled battery using used batteries, wherein the assembled battery comprises a serial body constituted by series connection of a plurality of parallel bodies, each of the parallel bodies being constituted by parallel connection of a plurality of batteries, an absolute value of difference between an evaluation value, which is obtained by dividing a reciprocal of an internal resistance value by a remaining active material amount, of each battery constituting each of the parallel bodies and a maximum evaluation value among the batteries constituting each of the parallel bodies is within 10 % of the maximum evaluation value, and an absolute value of difference between a residual capacity in a fully charged state of each parallel body constituting the serial body and a maximum residual capacity among the parallel bodies constituting the serial body is within 10 % of the maximum residual capacity.

With this construction, a situation in which the electric current amount per active material of the battery having a small internal resistance increases to promote the deterioration can be avoided, and also a situation in which the battery having a small residual capacity is overcharged and overly discharged to promote the deterioration can be avoided, so that an assembled battery can be provided in which the deterioration is not promoted even when the used batteries are used.

BRIEF DESCRIPTION OF THE DRAWINGS

FIG. 1     is a block diagram illustrating one example of a system for executing a residual capacity prediction method and measurement of remaining active material amount of the present invention.

FIG. 2A     is a perspective view schematically illustrating a sealed secondary battery.

FIG. 2B     is an A-A sectional view in FIG. 2A.

FIG. 3     is a graph showing a first curved line and a reference curved line.

FIG. 4     is a graph showing a second curved line determined by a fitting treatment.

FIG. 5     is a flowchart showing an assembled battery manufacturing method of the present invention.

Fig.6     is a flowchart showing an assembled battery manufacturing method of the present invention.

FIG. 7     is a flowchart showing an assembled battery manufacturing method of the present invention.

MODE FOR CARRYING OUT THE INVENTION

An embodiment of the present invention will be explained.

First, a system in which the assembled battery of the present invention is used will be described.

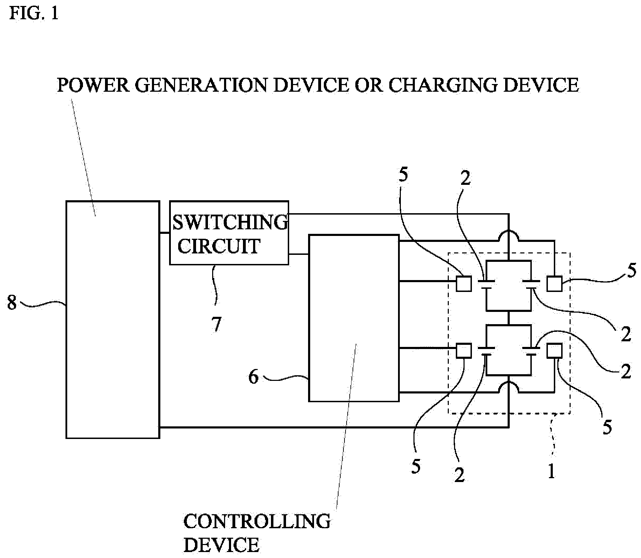

FIG. 1 shows a system that is mounted on an electrically driven vehicle such as an electric automobile or a hybrid car. This system includes a battery module 1 in which an assembled battery constructed with a plurality of sealed secondary batteries 2 is accommodated in a case. In the present embodiment, four secondary batteries 2 are connected in an arrangement of two in parallel by two in series; however, the number of batteries or the connection mode is not limited to this alone. In FIG. 1, only one battery module 1 is shown.

Actually, however, the batteries are mounted as a battery pack including a plurality of battery modules 1. In the battery pack, a plurality of battery modules 1 are connected in series, and the battery modules 1 are accommodated in a case together with various apparatus such as a controller. The case of the battery pack is formed in a shape suitable for mounting on a vehicle, for example, a shape that conforms to the under-floor shape of the vehicle.

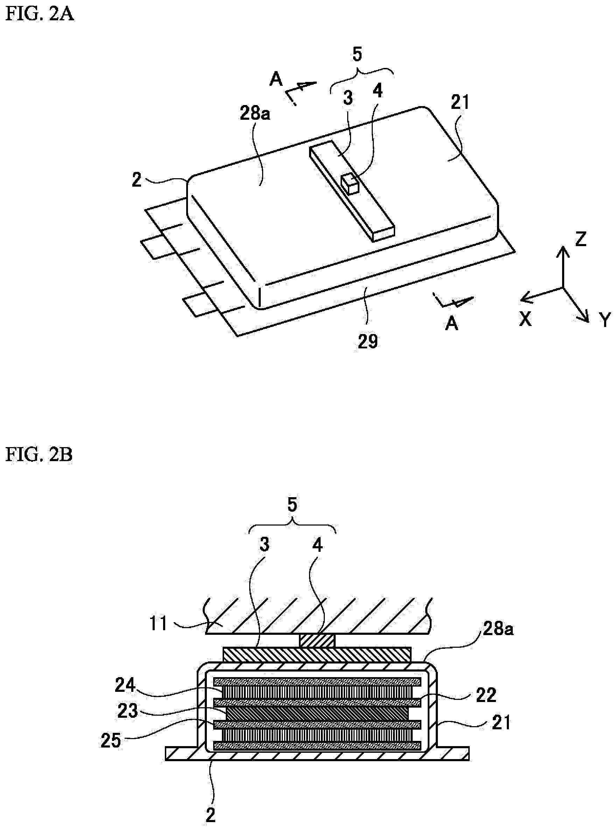

The secondary battery 2 shown in FIG. 2 is constructed as a cell (unit cell) in which an electrode group 22 is accommodated in the inside of a sealed outer casing 21. The electrode group 22 has a structure in which a positive electrode 23 and a negative electrode 24 are stacked or wound via a separator 25 interposed therebetween, and an electrolytic solution is held in the separator 25.

The secondary battery 2 of the present embodiment is a laminate battery using a laminate film such as an aluminum laminate foil as the outer casing 21, and is specifically a laminate-type lithium ion secondary battery having a capacity of 1.44 Ah. The secondary battery 2 is formed to have a thin-type rectangular parallelepiped shape as a whole. The X-, Y-, and Z-directions correspond to the length direction, the width direction, and the thickness direction, respectively, of the secondary battery 2. Also, the Z-direction is the thickness direction of the positive electrode 23 and the negative electrode 24.

A detection sensor 5 that detects deformation of the secondary battery 2 is mounted on the secondary battery 2. The detection sensor 5 includes a polymer matrix layer 3 attached to the secondary battery 2 and a detection unit 4. The polymer matrix layer 3 contains a filler that is dispersed therein and that changes an external field in response to deformation of the polymer matrix layer 3. The polymer matrix layer 3 of the present embodiment is in a sheet form and is formed of an elastomer material that is capable of flexible deformation.

The detection unit 4 detects the change in the external field accompanying the deformation of the polymer matrix layer 3. When the secondary battery 2 swells to be deformed, the polymer matrix layer 3 is deformed in accordance therewith, and change in the external field accompanying the deformation of the polymer matrix layer 3 is detected by the detection unit 4. In this manner, deformation of the secondary battery 1 can be detected with a high degree of sensitivity.

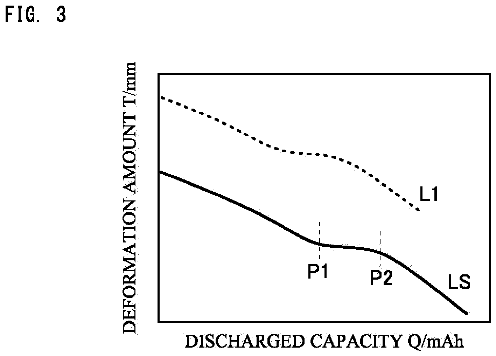

In the example shown in FIG. 2, the polymer matrix layer 3 is attached to the outer casing 21 of the secondary battery 2, so that the polymer matrix layer 3 can be deformed in accordance with the deformation (mainly the swelling) of the outer casing 21. Alternatively, the polymer matrix layer 3 may be attached to the electrode group 22 of the secondary battery 2 as shown in FIG. 3. According to such a construction, the polymer matrix layer 3 can be deformed in accordance with the deformation (mainly the swelling) of the electrode group 22. The deformation of the secondary battery 1 to be detected may be a deformation of either the outer casing 21 or the electrode group 22.

Signals obtained by detection with the detection sensor 5 are transmitted to a controlling device 6, whereby information on the deformation of the secondary battery 2 is supplied to the controlling device 6.

Assembled battery manufacturing method

Next, a method for manufacturing an assembled battery using used secondary batteries 2 will be described.

As a result of studies made by the present inventors, the following has been found out.

1) When batteries are connected in series, an equivalent electric current flows through each of the batteries. That is, when the residual capacities of the batteries that are in a series connection relationship are not equivalent from each other, the battery having the smallest capacity falls into an overly discharged state to promote battery deterioration during the discharging. If the discharging is stopped to meet the capacity of the battery having the smallest capacity, the discharging is stopped while the other batteries still have a capacity left, so that the batteries cannot be efficiently used.

On the other hand, the battery having the smallest capacity reaches an overcharged state during the charging. The battery that has reached an overcharged state raises an increased fear of explosion and ignition. If the charging is stopped when the battery having the smallest capacity comes into a fully charged state, the charging is stopped in a state in which the other batteries are not sufficiently charged, so that the batteries cannot be efficiently used. In other words, in recycling and turning the used batteries into an assembled battery, batteries having uniform residual capacities must be selected and connected in series.

2) When a battery is used for a long period of time, decomposed products and the like of an electrolytic solution may be deposited onto an electrode surface to increase the internal resistance of the battery. When batteries are connected in parallel, the voltages of the batteries that are in a parallel relationship are equivalent to each other.

That is, when batteries that are in a parallel connection relationship and differ in internal resistance are charged or discharged, different electric currents flow through the batteries due to the difference of resistance in the respective batteries. Among the batteries that are connected in parallel, the electric current that flows through a battery having a larger internal resistance is smaller, and the electric current is concentrated into the battery having a small internal resistance.

That is, a large electric current flows through a sound battery having a small internal resistance, and deterioration of the sound battery is promoted due to charging/discharging with the large electric current. In order to suppress deterioration of the batteries, parallel connection must be constituted with batteries having uniform internal resistances. Also, the electric current value permitted in a battery (electric current value that does not promote the deterioration) is determined by an electric current value per active material in the inside of the battery.

When the same electric current is let to flow through the batteries, the electric current value per active material is larger in a battery having a decreased effective amount of a remaining active material due to deactivation or the like of the active material as compared with a battery in which the active material amount has not decreased. In other words, in order to suppress battery deterioration, the batteries must be connected so that the electric current values per effective amount of a remaining active material may be equivalent to each other. For that purpose, the used batteries must be selected so that the value which is obtained by dividing a reciprocal of the internal resistance of the battery by the remaining active material amount may become equivalent.

3) When a battery is charged, the active material that stores ions swells. For this reason, the electrode active material, and further the battery itself, swells and shrinks in accordance with the charging/discharging of the battery. The amount of swell and shrinkage of the battery is correlated to the amount of stored ions, so that the residual capacity of the battery can be measured by observing change in the thickness of the battery.

4) An effective amount of the active material that contributes to charging/discharging can be estimated by the swelling behavior of the battery.

The conclusions stated above were obtained by the following experiments.

Battery A; new product

First, commercially available lithium ion batteries for consumer use having the same voltage and rated capacity (3.0 V to 4.2 V, rated capacity of 1440 mAh) were prepared. The new product batteries were named as batteries A.

Battery B; Battery subjected to deterioration treatment by high-temperature storage

The aforementioned commercially available batteries for consumer use were subjected to constant-current constant-voltage charging up to 4.2 V with an electric current of 288 mA (charging was finished at an electric current value of 72 mA), and were stored for one month in a thermostatic tank of 60°C in a fully charged state as it was. Thereafter, the batteries were subjected to constant-current discharging down to 3.0 V with an electric current of 288 mA.

Further, the batteries were again subjected to constant-current constant-voltage charging up to 4.2 V with an electric current of 288 mA (charging was finished at an electric current value of 72 mA), and thereafter subjected to constant-current discharging down to 3.0 V with an electric current of 288 mA. The discharged capacity at this time was determined as a discharged capacity after deterioration. These batteries subjected to the deterioration treatment were named as batteries B.

Battery C; battery subjected to cycle deterioration treatment

The aforementioned commercially available batteries for consumer use were subjected to repetition for 300 times of a charging/discharging cycle of performing constant-current constant-voltage charging up to 4.2 V with an electric current of 1440 mA (charging was finished at an electric current value of 72 mA) and thereafter performing constant-current discharging down to 3.0 V with an electric current of 1440 mA. Subsequently, the batteries were subjected to constant-current constant-voltage charging up to 4.2 V with an electric current of 288 mA (charging was finished at an electric current value of 72 mA), and thereafter subjected to constant-current discharging down to 3.0 V with an electric current of 288 mA. The discharged capacity at this time was determined as a discharged capacity after deterioration. These batteries subjected to the deterioration treatment were named as batteries C.

Measurement of residual capacity

Change in thickness during the charging/discharging of the aforementioned commercially available battery 2 for consumer use was measured. The residual capacity of the secondary battery 2 was predicted by using information on the deformation of this secondary battery 2. Specifically, deformation of the secondary battery 2 is detected during the charging/discharging cycle C1 before the time point of predicting the residual capacity, and a first curved line representing the relationship between the charged/discharged capacity and the deformation amount of the secondary battery 2 is determined (Step 1).

The charged/discharged capacity is a general term for the discharged capacity and the charged capacity. Here, an example is shown in which the charged/discharged capacity is the discharged capacity from a fully charged state. The graph of FIG. 3 shows a first curved line L1 representing the relationship between the discharged capacity from a fully charged state and the deformation amount of the secondary battery 2, as determined during the charging/discharging cycle C1.

A reference curved line LS represents the relationship between the charged/discharged capacity (discharged capacity from a fully charged state in the present embodiment) and the deformation amount of the secondary battery 2 in a predetermined reference state. The reference curved line LS is determined by using a secondary battery 2 at an initial stage before being deteriorated as a reference state, for example, by using a secondary battery 2 at the time of production or before being shipped.

The first curved line L1 and the reference curved line LS assume a shape including concavity and convexity (change in slope) of some degree, as shown in FIG. 3, due to stage change of the electrode. For example, in the case of a lithium ion secondary battery using graphite (black lead) in the negative electrode, the crystal state of the graphite is known to undergo stage change sequentially according as the discharging from a fully charged state proceeds.

This is because the negative electrode active material swells by stepwise enlargement of the distance between the graphene layers in accordance with the intercalation amount of lithium ions. To sum up, the volume of the active material changes in a stepwise manner by stage change, and this is reflected on the first curved line L1 and the reference curved line LS.

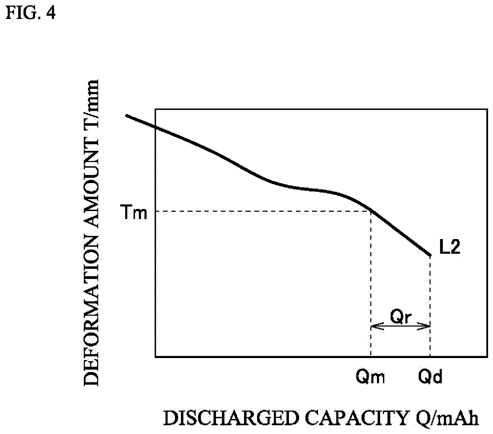

After the Step 1, a second curved line L2 is determined by performing a treatment of fitting the reference curved line LS to the first curved line L1 (Step 2). As already described, the first curved line L1 is determined in the above Step 1, and the reference curved line LS is determined in advance in a reference state before deterioration. The fitting treatment can be carried out by a generally used technique such as the least square method. The graph of FIG. 4 shows a second curved line L2 determined by the fitting treatment.

In the fitting treatment, four parameters, which are the "enlargement ratio Xr of the charged/discharged capacity" corresponding to the enlargement ratio of the length of the reference curved line LS in the X-axis direction, the "shift amount Xs of the charged/discharged capacity" corresponding to the shift amount of the reference curved line LS in the X-axis direction, the "enlargement ratio Yr of the deformation amount" corresponding to the enlargement ratio of the length of the reference curved line LS in the Y-axis direction, and the "shift amount Ys of the deformation amount" corresponding to the shift amount of the reference curved line LS in the Y-axis direction, were changed.

Further, the deformation amount Tm of the secondary battery 2 is detected during the charging/discharging cycle C2 after the charging/discharging cycle C1 (Step 3). After the Steps 1 to 3, the charged/discharged capacity Qm corresponding to the deformation amount Tm of the secondary battery 2 is acquired on the basis of the second curved line L2, as shown in FIG. 4, and the difference between the charged/discharged capacity Qd in the completely discharged state and the charged/discharged capacity Qm in the second curved line L2 is determined as a residual capacity Qr (Step 4). The residual capacity Qr obtained by subtracting the charged/discharged capacity Qm from the charged/discharged capacity Qd in the completely discharged state is a predicted value of the residual capacity at that time point.

In other words, the charged/discharged capacity Qm is determined on the basis of the detected deformation amount Tm of the secondary battery 2 and the second curved line L2 determined by the fitting treatment, and the residual capacity Qr is determined from the charged/discharged capacity Qm and the charged/discharged capacity Qd. It goes without saying that the measurement of the residual capacity is carried out by the aforementioned method; however, the present invention is not limited to this alone, so that other techniques already known in the art can be used as well.

Measurement of effective amount of remaining active material

Change in the thickness of the above commercially available battery 2 for consumer use during the charging/discharging was measured. The behavior of change in the thickness of the battery from the fully charged state of 4.2 V to complete discharge down to 3.0 V is as shown in the reference curved line LS in FIG. 3. A point at which the slope changes can be confirmed in the reference curved line LS. As described above, this is due to stage change of the negative electrode graphite.

The stage of the negative electrode is determined by the number of lithium atoms relative to the carbon atoms, so that the capacity in this interval is correlated to the amount of the negative electrode active material contributing to the discharging. In other words, the effective amount of the remaining active material used after deterioration can be measured by making comparison of the capacity between P1 and P2 during the discharging before the deterioration and after the deterioration. The amount of the remaining active material is represented by the following formula.

$$\text{Amount of remaining active material} = [\text{capacity between P1 and P2 after deterioration}]/[\text{capacity between P1 and P2 before deterioration}]$$

Measurement of internal resistance of battery

Measurement of the internal resistance of the battery was carried out by making calculation based on the result of the voltage measured when the battery was discharged for 10 seconds with a constant electric current in a state in which the charging depth of the battery was 50 % and the following formula.

$$\text{Internal resistance } [\Omega] = (\text{voltage before electric current is let to flow} - \text{voltage after 10 seconds})/(\text{value of electric current let to flow})$$

Characteristics of batteries A to C

The characteristics of batteries A, B, and C are shown in Table 1.

[Table 1]

| Battery name | Deterioration treatment method | Residual capacity in fully charged state [mAh] | Amount of remaining active material [%] | Internal resistance [Ω] | 1/internal resistance/ amount of remaining active material |
|---|---|---|---|---|---|
| A | Without treatment | 1440 | 100 | 15 | 0.000666667 |
| B | Storage at 60°C | 1322 | 96 | 18 | 0.000578704 |
| C | 300 cycles | 1263 | 87 | 15.8 | 0.000727484 |

EXAMPLES

The following evaluation was made on the following Examples in order to specifically show the assembled battery manufacturing method and the effects of the present invention.

(1) Capacity retention rate

The initial battery capacity was measured, and also the discharged capacity after repeating the charging/discharging cycle for 300 times was measured, so as to calculate the capacity retention rate by the following formula.

$$\text{Capacity retention rate } [\%] = (\text{discharged capacity after repeating charging/discharging cycle for 300 times})/(\text{initial battery capacity}) \times 100$$

Two in series

Example 1

A serial body was formed by connecting a battery A and a battery B in series.
This serial body was subjected to constant-current constant-voltage charging up to 8.4 V with an electric current of 288 mA (charging was finished at an electric current value of 72 mA), and thereafter subjected to constant-current discharging down to 6.0 V with an electric current of 288 mA. The discharged capacity at this time was determined as the initial capacity.
Subsequently, the serial body was subjected to repetition for 300 times of a charging/discharging cycle of performing constant-current constant-voltage charging up to 8.4 V with an electric current of 1440 mA (1C) (charging was finished at an electric current value of 72 mA) and thereafter performing constant-current discharging down to 6.0 V with an electric current of 1440 mA.
Further, the serial body was subjected to constant-current constant-voltage charging up to 8.4 V with an electric current of 288 mA (charging was finished at an electric current value of 72 mA), and thereafter subjected to constant-current discharging down to 6.0 V with an electric current of 288 mA. The discharged capacity at this time was determined as the deteriorated capacity.

Reference 1

One serial body was formed by connecting two batteries A in series. The method of measuring the initial capacity and the deteriorated capacity is the same as that of Example 1.

Comparative Example 1

One serial body was formed by connecting a battery A and a battery C in series. The method of measuring the initial capacity and the deteriorated capacity is the same as that of Example 1.

Two in parallel

Example 2

One parallel body was formed by connecting a battery A and a battery C in parallel.

This parallel body was subjected to constant-current constant-voltage charging up to 4.2 V with an electric current of 576 mA (charging was finished at an electric current value of 144 mA), and thereafter subjected to constant-current discharging down to 3.0 V with an electric current of 576 mA. The discharged capacity at this time was determined as the initial capacity.

Subsequently, the parallel body was subjected to repetition for 300 times of a charging/discharging cycle of performing constant-current constant-voltage charging up to 4.2 V with an electric current of 2880 mA (1C) (charging was finished at an electric current value of 144 mA) and thereafter performing constant-current discharging down to 3.0 V with an electric current of 2880 mA.

Further, the parallel body was subjected to constant-current constant-voltage charging up to 4.2 V with an electric current of 576 mA (charging was finished at an electric current value of 144 mA), and thereafter subjected to constant-current discharging down to 3.0 V with an electric current of 576 mA. The discharged capacity at this time was determined as the deteriorated capacity.

Reference 2

One parallel body was formed by connecting two batteries A in parallel. The method of measuring the initial capacity and the deteriorated capacity is the same as that of Example 2.

Comparative Example 2

One parallel body was formed by connecting a battery A and a battery B in parallel. The method of measuring the initial capacity and the deteriorated capacity is the same as that of Example 2.

Comparative Example 3

One parallel body was formed by connecting a battery B and a battery C in parallel. The method of measuring the initial capacity and the deteriorated capacity is the same as that of Example 2.

Two in parallel, two in series

Example 3

A parallel body having a battery A and a battery C connected in parallel and a parallel body having two batteries B connected in parallel were connected in series to form one serial body.

This serial body was subjected to constant-current constant-voltage charging up to 8.4 V with an electric current of 576 mA (charging was finished at an electric current value of 144 mA), and thereafter subjected to constant-current discharging down to 6.0 V with an electric current of 576 mA. The discharged capacity at this time was determined as the initial capacity.

Subsequently, the serial body was subjected to repetition for 300 times of a charging/discharging cycle of performing constant-current constant-voltage charging up to 8.4 V with an electric current of 2880 mA (1C) (charging was finished at an electric current value of 144 mA) and thereafter performing constant-current discharging down to 6.0 V with an electric current of 2880 mA.

Further, the serial body was subjected to constant-current constant-voltage charging up to 8.4 V with an electric current of 576 mA (charging was finished at an electric current value of 144 mA), and thereafter subjected to constant-current discharging down to 6.0 V with an electric current of 576 mA. The discharged capacity at this time was determined as the deteriorated capacity.

Reference 3

Two parallel bodies, each having two batteries A connected in parallel, were connected in series to form one serial body. The method of measuring the initial capacity and the deteriorated capacity is the same as that of Example 3.

Comparative Example 4

A parallel body having a battery A and a battery B connected in parallel and a parallel body having a battery B and a battery C connected in parallel were connected in series to form one serial body. The method of measuring the initial capacity and the deteriorated capacity is the same as that of Example 3.

Calculation of capacity difference in series connection

The capacity difference in series connection was calculated by the following formula.

$$\text{Capacity difference [\%] in series connection} = \text{[absolute value of difference in capacity relative to maximum capacity value among batteries that are in series connection relationship]}/\text{[maximum capacity value]} \times 100$$

In Example 1, the capacity difference in series connection is

$$\left| 1440 - 1322 \right| /1440 \times 100 = 8.19444\ldots \approx 8.2 \ \%.$$

In Example 3, the capacity of the parallel body is a sum of the capacities of the batteries. The maximum capacity is attained in the parallel body having the battery A and the battery C connected in parallel, and the capacity thereof is 1440 + 1263 = 2703 mAh. The absolute value of the capacity difference is |(capacity of battery A + capacity of battery C) - (capacity of battery B + capacity of battery B)| = |(1440 + 1263) - (1322 + 1322)1 = 59. Therefore, the capacity difference [%] in Example 3 is 59/2703 $\times$ 100 = 2.18276 % $\approx$ 2.2 %.

Calculation of difference in evaluation value in parallel connection

A value obtained by dividing a reciprocal of the internal resistance by the remaining active material amount was determined as the evaluation value.
The evaluation value difference in parallel connection was calculated by the following formula.

$$\text{Evaluation value difference [\%] in parallel connection} = \text{[absolute value of difference in evaluation value relative to maximum evaluation value among batteries that are in parallel connection relationship]}/\text{[maximum evaluation value]} \times 100$$

In Example 2, the evaluation value difference in parallel connection is |evaluation value of battery A - evaluation value of battery C|/(evaluation value of battery C) $\times$ 100 = |0.000666667 - 0.000727484|/0.000727484 $\times$ 100 = 8.36 $\approx$ 8.4 %.

[Table 2]

| | Example 1 | Reference 1 | Comparative Example 1 | Example 2 | Reference 2 | Comparative Example 2 | Comparative Example 3 | Example 3 | Reference 3 | Comparative Example 4 |
|---|---|---|---|---|---|---|---|---|---|---|
| Method of arrangement | A–B (series A,B) | A–A (series A,A) | A–C (series A,C) | A∥C (parallel A,C) | A∥A (parallel A,A) | A∥B (parallel A,B) | B∥C (parallel B,C) | A∥C / B∥B | A∥A / A∥A | A∥B / B∥C |
| Capacity difference in serial connection [%] | 8.2 | 0.0 | 12.3 | - | - | - | - | 2.2 | 0.0 | 6.4 |
| Difference of evaluation value in parallel connection [%] | - | - | - | 8.4 | 0.0 | 13.1 | 20.4 | 8.4 / 0.0 | 0.0 / 0.0 | 13.1 / 20.4 |
| Initial capacity [mAh] | 1420.0 | 1440.0 | 1300.0 | 2680.0 | 2880.0 | 2820.0 | 2620.0 | 2700.0 | 2880.0 | 2700.0 |
| Deteriorated capacity [mAh] | 1334.8 | 1368.0 | 1157.0 | 2546.0 | 2736.0 | 2453.4 | 2122.2 | 2538.0 | 2736.0 | 2295.0 |
| Capacity retention rate [%] | 94.0 | 95.0 | 89.0 | 95.0 | 95.0 | 87.0 | 81.0 | 94.0 | 95.0 | 85.0 |

Determination of battery deterioration

Regarding whether the deterioration of the battery is suppressed or not, the case in which the capacity retention rate after 300 cycles was within minus 3 % was determined as having "suppressed deterioration", whereas the case other than that was determined as having "promoted deterioration". In other words, since the capacity retention rate is 95 % in the References 1, 2, and 3 each of which is directed to a combination of new product batteries with each other, the method of arrangement in which the capacity retention rate is 92 % or more can be regarded as having suppressed deterioration.

With respect to Example 1, Reference 1, and Comparative Example 1 with series connection, the capacity retention rate is 94 % in Example 1 in which the capacity difference in series connection is less than 10 %. Since the capacity decrease in Example 1 is within 3 % relative to the capacity retention rate of 95 % in the Reference 1, it can be determined that the deterioration was suppressed. On the other hand, since the capacity retention rate is 89 % in the Comparative Example 1, and the capacity is deteriorated by 6 % as compared with that of the Reference 1, it is assumed that the deterioration was promoted.

This is assumed to be because the battery C in the Comparative Example 1 fell into an overcharged state during the charging and fell into an overly discharged state during the discharging, so that the battery deterioration was promoted. Also, in Comparative Example 1, the initial capacity of 1300 mAh is considerably larger than the capacity of the battery C alone of 1263 mAh, thereby showing an overcharged state.

With respect to Example 2, Reference 2, and Comparative Examples 2 and 3 with parallel connection, difference in the evaluation value, which is obtained by dividing a reciprocal of the internal resistance by the remaining active material amount, exceeds 10 %, and the capacity retention rates thereof are 87 % and 81 %, respectively, in Comparative Examples 2 and 3, so that it can be determined that the deterioration is considerable as compared with the Reference 2.

This is assumed to be because, in the Comparative Examples 2 and 3, the electric current amount per active material in the battery having a low resistance increased, and the deterioration was promoted. On the other hand, in Example 2 in which the difference in evaluation value is within 10 %, the capacity retention rate thereof is 95 % which exceeds the determination standard of 92 %, so that it can be determined that the deterioration did not occur.

With respect to Example 3, Reference 3, and Comparative Example 4 with parallel and series connection, though the capacity difference in series connection is within 10 % in Comparative Example 4, difference in the evaluation value in parallel connection exceeds 10 %, and the capacity retention rate is 85 % which is lower than the determination standard of 92 %.

In particular, though Example 3 and the Comparative Example 4 have the same construction in which one battery A, two batteries B, and one battery C are used, the degree of deterioration during the recycling is considerably different depending on the method of arrangement.

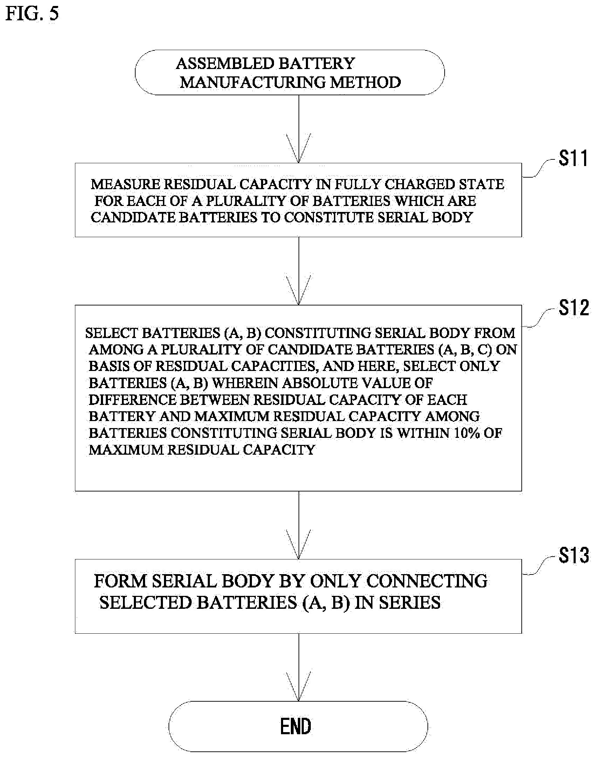

In view of the above, an assembled battery manufacturing method using used batteries is preferably carried out in accordance with the procedure shown in Figs. 5 to 7.

For example, in the assembled battery manufacturing method having a serial body constituted by series connection of a plurality of batteries such as in Example 1, the residual capacity in a fully charged state for each of the plurality of batteries (A, B, C) which are candidate batteries to constitute the serial body is measured, as shown in FIG. 5 (Step S11). Next, on the basis of the residual capacities, the batteries (A, B) constituting the serial body are selected from among the plurality of candidate batteries (A, B, C) (Step S12).

Next, the serial body is formed by only connecting the selected batteries (A, B) in series (Step S13). Here, in the Step S12 of selecting the batteries, only the batteries (A, B) wherein an absolute value of the difference between the residual capacity of each battery and the maximum residual capacity among the batteries constituting the serial body is within 10 % of the maximum residual capacity, are selected.

By performing this process, a situation in which the battery having a small residual capacity is overcharged and overly discharged to promote the deterioration can be avoided, so that an assembled battery can be manufactured in which the deterioration is not promoted even when the used batteries are used.

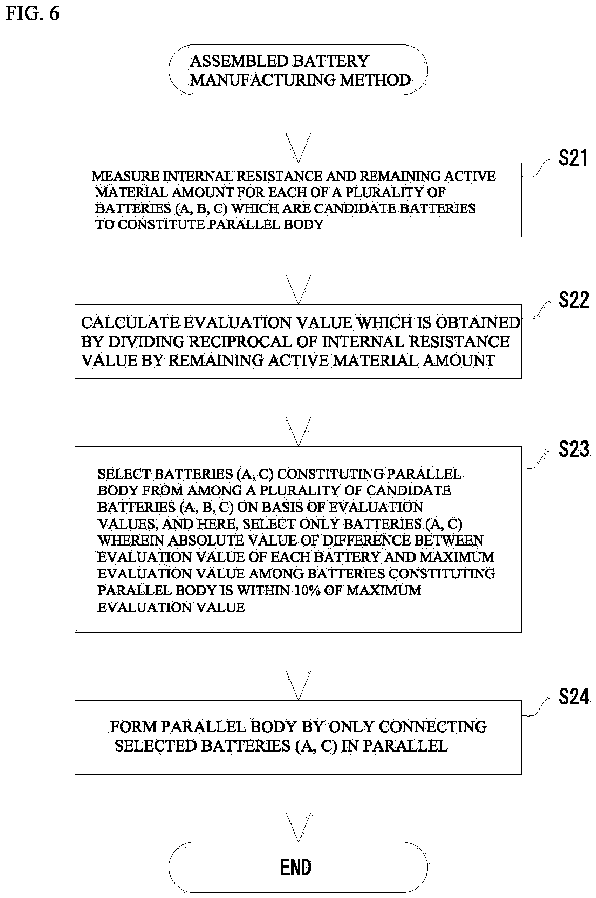

Also, in the assembled battery manufacturing method having a parallel body constituted by parallel connection of a plurality of batteries as in Example 2, the internal resistance and the remaining active material amount for each of the plurality of batteries (A, B, C) which are candidate batteries to constitute the parallel body are measured, as shown in FIG. 6 (Step S21). Next, an evaluation value, which is obtained by dividing a reciprocal of the internal resistance value by the remaining active material amount, is calculated (Step S22).

Next, on the basis of the evaluation values, the batteries (A, C) constituting the parallel body are selected from among the plurality of candidate batteries (A, B, C) (Step S23). Next, the parallel body is formed by only connecting the selected batteries (A, C) in parallel (Step S24). Here, in the step S23 of selecting the batteries, only the batteries (A, C) wherein an absolute value of the difference between the evaluation value of each battery and the maximum evaluation value among the batteries constituting the parallel body is within 10 % of the maximum evaluation value, are selected.

By performing this process, a situation in which the electric current amount per active material of the battery having a small internal resistance increases to promote the deterioration can be avoided, so that an assembled battery can be manufactured in which the deterioration is not promoted even when the used batteries are used.

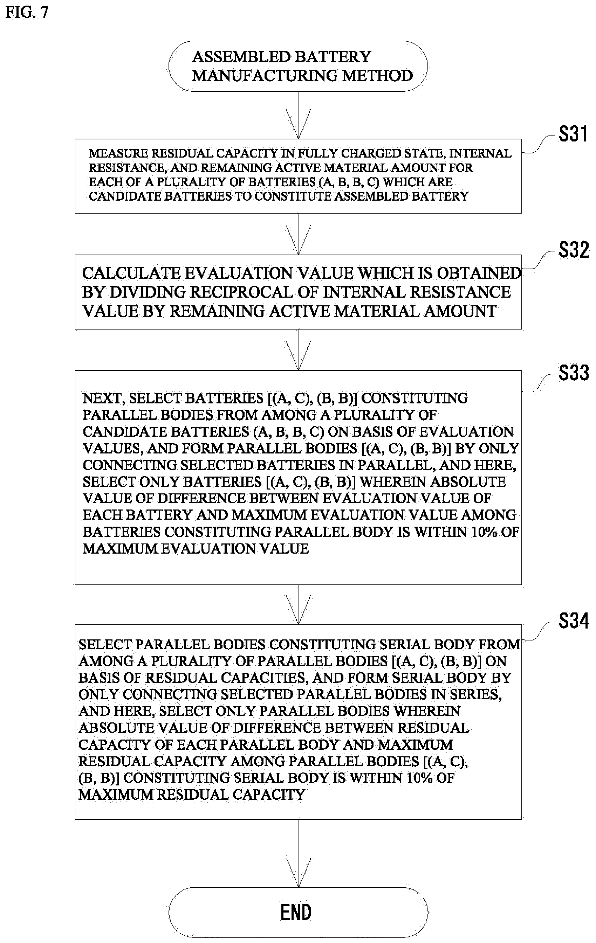

Also, in the assembled battery manufacturing method having a serial body constituted by series connection of a plurality of parallel bodies, each of the parallel bodies being constituted by parallel connection of a plurality of batteries as in Example 3, the residual capacity in a fully charged state, the internal resistance, and the remaining active material amount for each of the plurality of batteries (A, B, B, C) which are candidate batteries to constitute the assembled battery are measured, as shown in FIG. 7 (Step S31).

Next, an evaluation value, which is obtained by dividing a reciprocal of the internal resistance value by the remaining active material amount, is calculated (Step S32). Next, on the basis of the evaluation values, the batteries [(A, C), (B, B)] constituting each of the parallel bodies are selected from among the plurality of candidate batteries (A, B, B, C), and form each of the parallel bodies [(A, C), (B, B)] by only connecting the selected batteries in parallel (Step S33). Here, only the batteries [(A, C), (B, B)] wherein an absolute value of the difference between the evaluation of each battery and a maximum evaluation value among the batteries constituting each of the parallel bodies is within 10 % of the maximum evaluation value, are selected.

Next, on the basis of the residual capacities, parallel bodies constituting the serial body are selected from among the plurality of parallel bodies [(A, C), (B, B)], and form the serial body by only connecting the selected parallel bodies in series (Step S34). Here, only the parallel bodies wherein an absolute value of the difference between the residual capacity of each parallel body and a maximum residual capacity among the parallel bodies [(A, C), (B, B)] constituting the serial body is within 10 % of the maximum residual capacity, are selected.

By performing this process, a situation in which the electric current amount per active material of the battery having a small internal resistance increases to promote the deterioration can be avoided, and also a situation in which the battery having a small residual capacity is overcharged and overly discharged to promote the deterioration can be avoided, so that an assembled battery can be manufactured in which the deterioration is not promoted even when the used batteries are used.

In the present embodiment, the residual capacity is measured on the basis of the deformation amount which is obtained by detecting the deformation of the battery.

In the present embodiment, the remaining active material amount is measured on the basis of the deformation amount which is obtained by detecting the deformation of the battery.

Both of the residual capacity and the remaining active material amount can be measured by detecting change in the thickness of the battery with use of a sensor provided in the battery, so that it is useful. Specifically, means for detecting the deformation of the battery includes a polymer matrix layer 3 containing a magnetic filler and a detection unit 4 that detects change in the magnetic field accompanying the deformation of the polymer matrix layer 3.

The present invention can also be specified as an assembled battery.

That is, the assembled battery of the present invention is an assembled battery using used batteries wherein the assembled battery includes a serial body constituted by series connection of a plurality of batteries, and an absolute value of the difference between a residual capacity in a fully charged state of each battery constituting the serial body and a maximum residual capacity among the batteries constituting the serial body is within 10 % of the maximum residual capacity.

With this construction, a situation in which the battery having a small residual capacity is overcharged and overly discharged to promote the deterioration can be avoided, so that an assembled battery can be provided in which the deterioration is not promoted even when the used batteries are used.

The assembled battery of the present invention is an assembled battery using used batteries wherein the assembled battery includes a parallel body constituted by parallel connection of a plurality of batteries, and an absolute value of the difference between an evaluation value, which is obtained by dividing a reciprocal of an internal resistance value by a remaining active material amount, of each battery constituting the parallel body and a maximum evaluation value among the batteries constituting the parallel body is within 10 % of the maximum evaluation value.

With this construction, a situation in which the electric current amount per active material of the battery having a small internal resistance increases to promote the deterioration can be avoided, so that an assembled battery can be provided in which the deterioration is not promoted even when the used batteries are used.

The assembled battery of the present invention is an assembled battery using used batteries wherein the assembled battery includes a serial body constituted by series connection of a plurality of parallel bodies, each of the parallel bodies being constituted by parallel connection of a plurality of batteries; an absolute value of the difference between an evaluation value, which is obtained by dividing a reciprocal of an internal resistance value by a remaining active material amount, of each battery constituting each of the parallel bodies and a maximum evaluation value among the batteries constituting each of the parallel bodies is within 10 % of the maximum evaluation value; and an absolute value of the difference between a residual capacity in a fully charged state of each parallel body constituting the serial body and a maximum residual capacity among the parallel bodies constituting the serial body is within 10 % of the maximum residual capacity.

With this construction, a situation in which the electric current amount per active material of the battery having a small internal resistance increases to promote the deterioration can be avoided, and also a situation in which the battery having a small residual capacity is overcharged and overly discharged to promote the deterioration can be avoided, so that an assembled battery can be provided in which the deterioration is not promoted even when the used batteries are used.

As an active material for use in the negative electrode of a lithium ion secondary battery, those capable of electrochemically intercalating and deintercalating lithium ions are used. In obtaining the first curved line L1 and the reference curved line LS having a shape including the concavity and convexity such as described above, a negative electrode containing graphite, hard carbon, soft carbon, silicon, sulfur, or the like, for example, is used, and among these, a negative electrode containing graphite is preferably used. Also, examples of the active material used in the positive electrode include $LiCoO_2$, $LiMn_2O_4$, $LiNiO_2$, $Li(MnAl)_2O_4$, $Li(NiCoAl)O_2$, $LiFePO_4$, and $Li(NiMnCo)O_2$.

In the embodiment shown in FIG. 2, the polymer matrix layer 3 is attached to a wall part 28a of the outer casing 21 that faces the electrode group 22 in the thickness direction of the positive electrode 23 and the negative electrode 24, that is, in the Z-direction (up-and-down direction in FIG. 2B). The outer surface of the wall part 28a corresponds to the upper surface of the outer casing 21. The polymer matrix layer 3 faces the electrode group 22 with the wall part 28a interposed therebetween, and is disposed parallel to the upper surface of the electrode group 22.

The electrode swelling is caused by a change in the thickness of the electrode group 22 accompanying the change in volume of the active material, so that the action in the Z-direction is large. Therefore, in the present embodiment in which the polymer matrix layer 3 is attached to the wall part 28a, the electrode swelling can be detected with a high degree of sensitivity and, as a result, the remaining capacity of the secondary battery 2 can be predicted at a high precision.

Also, the polymer matrix layer 3 is attached in the thickness direction of the positive electrode 23 and the negative electrode 24, that is, in the Z-direction (up-and-down direction in FIG. 3(b)), relative to the electrode group 22. This allows that, even when the outer casing is formed of a robust material such as a metal can, the swelling of the electrode group 22 thereof, that is, the electrode swelling, can be detected with a high degree of precision and, as a result, the remaining capacity of the secondary battery 2 can be predicted at a high precision.

The detection unit 4 is disposed at a site where the change in the external field can be detected, and is preferably attached to a comparatively firm site that is hardly affected by the swelling of the secondary battery 2. In the present embodiment, the detection unit 4 is attached to an inner surface of a case 11 of the battery module that faces the wall portion 28a, as shown in FIG. 2B.

The case 11 of a battery module is formed, for example, of a metal or a plastic, and there may be cases in which a laminate film is used as the case 11 of the battery module. In the drawings, the detection unit 4 is disposed close to the polymer matrix layer 3; however, the detection unit 4 may be disposed to be distant from the polymer matrix layer 3.

The present embodiment is an example in which the polymer matrix layer 3 contains a magnetic filler as the above-described filler, and the detection unit 4 detects change in a magnetic field as the above-described external field. In this case, the polymer matrix layer 3 is preferably a magnetic elastomer layer in which the magnetic filler is dispersed in a matrix that contains an elastomer component.

The magnetic filler may be, for example, a rare-earth-based, iron-based, cobalt-based, nickel-based, or oxide-based filler; however, a rare-earth-based filler is preferable because a higher magnetic force can be obtained. The shape of the magnetic filler is not particularly limited, so that the shape may be any one of spherical, flattened, needle-like, prismatic, and amorphous shapes.

The average particle size of the magnetic filler is preferably from 0.02 $\mu$m to 500 $\mu$mm, more preferably from 0.1 $\mu$m to 400 $\mu$mm, and still more preferably from 0.5 $\mu$m to 300 $\mu$mm. When the average particle size is smaller than 0.02 $\mu$mm, the magnetic characteristics of the magnetic filler tend to deteriorate. On the other hand, when the average particle size exceeds 500 $\mu$mm, the mechanical properties of the magnetic elastomer layer tend to deteriorate, and the magnetic elastomer layer tends to be brittle.

The magnetic filler may be introduced into the elastomer after magnetization; however, it is preferable to magnetize the magnetic filler after introduction into the elastomer. By magnetization after introduction into the elastomer, the polarity of the magnet can be easily controlled, and the magnetic field can be easily detected.

A thermoplastic elastomer, a thermosetting elastomer, or a mixture of these can be used as the elastomer component. Examples of the thermoplastic elastomer include a styrene-based thermoplastic elastomer, a polyolefin-based thermoplastic elastomer, a polyurethane-based thermoplastic elastomer, a polyester-based thermoplastic elastomer, a polyamide-based thermoplastic elastomer, a polybutadiene-based thermoplastic elastomer, a polyisoprene-based thermoplastic elastomer, and a fluororubber-based thermoplastic elastomer.

Also, examples of the thermosetting elastomer include diene-based synthetic rubbers such as polyisoprene rubber, polybutadiene rubber, styrenebutadiene rubber, polychloroprene rubber, nitrile rubber, and ethylene-propylene rubber, non-diene-based synthetic rubbers such as ethylene-propylene rubber, butyl rubber, acrylic rubber, polyurethane rubber, fluororubber, silicone rubber, and epichlorohydrin rubber, and natural rubbers.

Among these, a thermosetting elastomer is preferable, and this is because settling of the magnetic elastomer accompanying the heat generation or overloading of the battery can be suppressed. Further, a polyurethane rubber (which may also be referred to as a polyurethane elastomer) or a silicone rubber (which may also be referred to as a silicone elastomer) is more preferable.

A polyurethane elastomer can be obtained by reacting a polyol with a polyisocyanate. In the case in which the polyurethane elastomer is used as the elastomer component, a magnetic filler is mixed with a compound containing active hydrogen, and further an isocyanate component is added thereto to obtain a mixture liquid. Also, a mixture liquid can also be obtained by mixing a magnetic filler with an isocyanate component, and mixing a compound containing active hydrogen thereto.

The magnetic elastomer can be produced by injecting the mixture liquid into a mold that has been subjected to a releasing treatment, and thereafter heating the mixture liquid up to a curing temperature for curing. Also, in the case in which a silicone elastomer is used as the elastomer component, the magnetic elastomer can be produced by putting a magnetic filler into a precursor of a silicone elastomer, mixing the components, putting the resulting mixture into a mold, and thereafter heating the mixture for curing. A solvent may be added as necessary.

A compound known in the art in the field of polyurethane can be used as the isocyanate component that can be used in the polyurethane elastomer. Examples of the isocyanate component include aromatic diisocyanates such as 2,4-toluene diisocyanate, 2,6-toluene diisocyanate, 2,2'-diphenylmethane diisocyanate, 2,4'-diphenylmethane diisocyanate, 4,4'-diphenylmethane diisocyanate, 1,5-naphthalene diisocyanate, p-phenylene diisocyanate, m-phenylene diisocyanate, p-xylylene diisocyanate, and m-xylylene diisocyanate, aliphatic diisocyanates such as ethylene diisocyanate, 2,2,4-trimethylhexamethylene diisocyanate, and 1,6-hexamethylene diisocyanate, and alicyclic diisocyanates such as 1,4-cyclohexane diisocyanate, 4,4'-dicyclohexylmethane diisocyanate, isophorone diisocyanate, and norbornane diisocyanate.

These may be used either alone or as a mixture of two or more kinds. Also, the isocyanate component may be a modified component such as a urethane-modified, allophanate-modified, biuret-modified, or isocyanurate-modified component. Preferable isocyanate components are 2,4-toluene diisocyanate, 2,6-toluene diisocyanate, and 4,4'-diphenylmethane diisocyanate. 2,4-toluene diisocyanate or 2,6-toluene diisocyanate is more preferable.

A compound typically used in the technical field of polyurethane can be used as the compound containing active hydrogen. Examples of the compound containing active hydrogen include high-molecular-weight polyols such as polyether polyols represented by polytetramethylene glycol, polypropylene glycol, polyethylene glycol, and a copolymer of propylene oxide and ethylene oxide, polyester polyols represented by polybutylene adipate, polyethylene adipate, and 3-methyl-1,5-pentane adipate, polyester polycarbonate polyols typified by reaction products of alkylene carbonate and polyester glycol such as polycaprolactone polyol or polycaprolactone, polyester polycarbonate polyols obtained by reacting ethylene carbonate with a polyhydric alcohol and subsequently reacting the obtained reaction mixture with an organic dicarboxylic acid, and polycarbonate polyols obtained by transesterification reaction of a polyhydroxyl compound and aryl carbonate. These may be used either alone or as a mixture of two or more kinds.

In addition to the above-described high-molecular-weight polyol components, low-molecular-weight polyol components such as ethylene glycol, 1,2-propylene glycol, 1,3-propylene glycol, 1,4-butanediol, 1,6-hexanediol, neopentyl glycol, 1,4-cyclohexanedimethanol, 3-methyl-1,5-pentanediol, diethylene glycol, triethylene glycol, 1,4-bis(2-hydroxyethoxy)benzene, trimethylolpropane, glycerin, 1,2,6-hexanetriol, pentaerythritol, tetramethylolcyclohexane, methylglucoside, sorbitol, mannitol, dulcitol, sucrose, 2,2,6,6-tetrakis(hydroxymethyl)cyclohexanol, and triethanolamine, and low-molecular-weight polyamine components such as ethylenediamine, tolylenediamine, diphenylmethanediamine, and diethylenetriamine may be used as the compound containing active hydrogen. These may be used either alone or as a mixture of two or more kinds.

Further, polyamines typified by 4,4'-methylenebis(o-chloroaniline) (MOCA), 2,6-dichloro-p-phenylenediamine, 4,4'-methylenebis(2,3-dichloroaniline), 3,5-bis(methylthio)-2,4-toluenediamine, 3,5-bis(methylthio)-2,6-toluenediamine, 3,5-diethyltoluene-2,4-diamine, 3,5-diethyltoluene-2,6-diamine, trimethyleneglycol-di-p-aminobenzoate, polytetramethyleneoxide-di-p-aminobenzoate, 1,2-bis(2-aminophenylthio)ethane, 4,4'-diamino-3,3'-diethyl-5,5'-dimethyldiphenylmethane, N,N'-di-sec-butyl-4,4'-diaminodiphenylmethane, 4,4'-diamino-3,3'-diethyldiphenylmethane, 4,4'-diamino-3,3'-diethyl-5,5'-dimethyldiphenylmethane, 4,4'-diamino-3,3'-diisopropyl-5,5'-dimethyldiphenylmethane, 4,4'-diamino-3,3',5,5'-tetraethyldiphenylmethane, 4,4'-diamino-3,3',5,5'-tetraisopropyldiphenylmethane, m-xylylenediamine, N,N'-di-sec-butyl-p-phenylenediamine, m-phenylenediamine, and p-xylylenediamine may also be mixed.

Preferable compounds containing active hydrogen are polytetramethylene glycol, polypropylene glycol, a copolymer of propylene oxide and ethylene oxide, and 3-methyl-1,5-pentane adipate. More preferable compounds containing active hydrogen are polypropylene glycol and a copolymer of propylene oxide and ethylene oxide.

A preferable combination of the isocyanate component and the compound containing active hydrogen is a combination of one kind or two more kinds of 2,4-toluene diisocyanate, 2,6-toluene diisocyanate, and 4,4'-diphenylmethane diisocyanate as the isocyanate component and one kind or two more kinds of polytetramethylene glycol, polypropylene glycol, a copolymer of propylene oxide and ethylene oxide, and 3-methyl-1,5-pentane adipate as the compound containing active hydrogen. A more preferable combination is a combination of 2,4-toluene diisocyanate and/or 2,6-toluene diisocyanate as the isocyanate component and polypropylene glycol and/or a copolymer of propylene oxide and ethylene oxide as the compound containing active hydrogen.

The polymer matrix layer 3 may be a foamed body containing a dispersed filler and bubbles. A general resin foam can be used as the foamed body. However, in view of the characteristics such as compression set, it is preferable to use a thermosetting resin foam. Examples of the thermosetting resin foam include polyurethane resin foam and silicone resin foam. Among these, polyurethane resin foam is preferable. The isocyanate component and the compound containing active hydrogen that have been listed above can be used for the polyurethane resin foam.

The amount of the magnetic filler in the magnetic elastomer is preferably 1 to 450 parts by weight, more preferably 2 to 400 parts by weight, relative to 100 parts by weight of the elastomer component. When the amount is smaller than 1 part by weight, detection of change in the magnetic field tends to be difficult. When the amount exceeds 450 parts by weight, the magnetic elastomer itself may in some cases become brittle.

For the purpose of preventing rusts of the magnetic filler or the like, a sealing material for sealing the polymer matrix layer 3 may be provided to such a degree that the flexibility of the polymer matrix layer 3 is not deteriorated. A thermoplastic resin, a thermosetting resin, or a mixture of these may be used as the sealing material.

The thermoplastic resin may be, for example, styrene-based thermoplastic elastomer, polyolefin-based thermoplastic elastomer, polyurethane-based thermoplastic elastomer, polyester-based thermoplastic elastomer, polyamide-based thermoplastic elastomer, polybutadiene-based thermoplastic elastomer, polyisoprene-based thermoplastic elastomer, fluorine-based thermoplastic elastomer, ethylene·ethyl acrylate copolymer, ethylene·vinyl acetate copolymer, polyvinyl chloride, polyvinylidene chloride, chlorinated polyethylene, fluororesin, polyamide, polyethylene, polypropylene, polyethylene terephthalate, polybutylene terephthalate, polystyrene, polybutadiene, or the like.

The thermosetting resin may be, for example, diene-based synthetic rubbers such as polyisoprene rubber, polybutadiene rubber, styrene·butadiene rubber, polychloroprene rubber, and acrylonitrile·butadiene rubber, non-diene-based rubbers such as ethylene·propylene rubber, ethylene·propylene·diene rubber, butyl rubber, acrylic rubber, polyurethane rubber, fluorine-containing rubber, silicone rubber, and epichlorohydrin rubber, natural rubbers, and thermosetting resins such as polyurethane resin, silicone resin, epoxy resin, or the like. These films may be stacked or may be a film including a metal foil such as aluminum foil or a metal vapor-deposition film including a metal vapor-deposited on the above-described film.

The polymer matrix layer 3 may be one in which the filler is unevenly distributed in the thickness direction thereof. For example, the polymer matrix layer 3 may be made of two layers, that is, a region on a one side containing a relatively larger amount of the filler and a region on the other side containing a relatively smaller amount of the filler. In the region that is located on the one side and that contains a larger amount of the filler, a large change in the external field results from small deformation of the polymer matrix layer 3, so that the sensor sensitivity to a low internal pressure can be enhanced.

Also, a region that is located on the other side and that contains a relatively smaller amount of the filler is comparatively flexible and can be easily moved. Therefore, by attaching this region located on the other side, the polymer matrix layer 3 (particularly the region located on the one side) becomes capable of being easily deformed.

The filler uneven distribution ratio in the region on the one side preferably exceeds 50, and is more preferably 60 or more, still more preferably 70 or more. In this case, the filler uneven distribution ratio in the region on the other side is less than 50. The filler uneven distribution ratio in the region on the one side is 100 at the maximum, and the filler uneven distribution ratio in the region on the other side is 0 at the minimum. Therefore, it is possible to adopt a stacked body structure including an elastomer layer that contains a filler and an elastomer layer that does not contain the filler.

For uneven distribution of the filler, it is possible to use a method in which, after the filler is introduced into the elastomer component, the resultant is left to stand still at room temperature or at a predetermined temperature, so as to attain natural settling of the filler by the weight of the filler. By changing the temperature or time for leaving the filler to stand still, the filler uneven distribution ratio can be adjusted. The filler may be distributed unevenly by using a physical force such as a centrifugal force or a magnetic force. Alternatively, the polymer matrix layer may be composed of a stacked body made of a plurality of layers having different contents of the filler.

The filler uneven distribution ratio is measured by the following method. That is, the cross-section of the polymer matrix layer is observed at a magnification of 100 times by using a scanning electron microscope - energy dispersive X-ray analyzer (SEM-EDS). The existence amount of the metal element inherent in the filler (for example, Fe element in the magnetic filler of the present embodiment) is determined by element analysis for the whole region in the thickness direction of the cross-section and for each of the two regions obtained by equally dividing the cross-section into two in the thickness direction. With respect to this existence amount, the ratio of the existence amount in the region on the one side relative to the existence amount in the whole region in the thickness direction is calculated, and this is determined as the filler uneven distribution ratio in the region on the one side. The filler uneven distribution ratio in the region on the other side can be determined in the same manner.

The region on the other side containing a relatively smaller amount of the filler may have a structure formed of a foamed body containing bubbles. This allows that the polymer matrix layer 3 can be more easily deformed, so that the sensor sensitivity is enhanced. Also, the region on the one side as well as the region on the other side may be formed of a foamed body. In this case, the whole of the polymer matrix layer 3 is made of a foamed body. The polymer matrix layer in which at least a part thereof in the thickness direction is made of a foamed body may be composed of a stacked body including a plurality of layers (for example, a non-foamed layer that contains a filler and a foamed layer that does not contain a filler).

As the detection unit 4 for detecting change in the magnetic field, a magnetic resistance element, a Hall element, an inductor, an MI element, a flux gate sensor, or the like can be used, for example. As the magnetic resistance element, a semiconductor compound magnetic resistance element, an anisotropic magnetic resistance element (AMR), a gigantic magnetic resistance element (GMR), and a tunnel magnetic resistance element (TMR) may be mentioned as examples. Among these, a Hall element is preferable, and this is because the Hall element has high sensitivity in a wide range, and is useful as the detection unit 4. As the Hall element, EQ-430L manufactured by Asahi Kasei Microdevices Corporation can be used, for example.

A secondary battery 2 in which gas swelling has proceeded may reach troubles such as ignition or rupture, so that the present embodiment is constructed in such a manner that the charging/discharging is shut off when an expansion amount at the time of deformation of the secondary battery 2 is above or equal to a predetermined level.

Specifically, signals obtained by detection with the detection sensor 5 are transmitted to the controlling device 6 and, when a change in the external field above or equal to a set value is detected by the detection sensor 5, the controlling device 6 sends signals to the switching circuit 7 and shuts off the electric current from the power generation device (or charging device) 8, so as to bring the system into a state in which charging/discharging of the battery module 1 is shut off. This allows that the troubles caused by gas swelling can be prevented.

In the above-described embodiment, an example in which the secondary battery is a lithium ion secondary battery has been shown; however, the present invention is not limited to this alone. The secondary battery that is put to use is not limited to a non-aqueous electrolyte secondary battery such as a lithium ion battery, but may be an aqueous electrolyte secondary battery such as a nickel hydrogen battery.

In the embodiments, an example has been shown in which change in the magnetic field accompanying the deformation of the polymer matrix layer is detected with the detection unit; however, it is possible to adopt a construction in which change in another external field is detected. For example, a construction may be considered in which the polymer matrix layer contains an electroconductive filler such as metal particles, carbon black, or carbon nanotubes as the filler, and the detection unit detects change in the electric field (change in the resistance and the dielectric constant) as the external field.

Structure employed at any of the foregoing embodiment(s) may be employed as desired at any other embodiment(s). The specific constitution of the various components is not limited only to the foregoing embodiment(s) but admits of any number of variations without departing from the gist of the present invention.

DESCRIPTION OF REFERENCE SIGNS

1     Battery module
2     Sealed secondary battery
3     Polymer matrix layer
4     Detection unit
5     Detection sensor
6     Controlling device
7     Switching circuit
8     Power generation device or charging device
11    Case
21    Outer casing
22    Electrode group
23    Positive electrode
24    Negative electrode
25    Separator
28a   Wall portion

**Claims**

1. An assembled battery manufacturing method using used batteries,
   wherein
   the assembled battery includes a serial body constituted by series connection of a plurality of batteries,
   the assembled battery manufacturing method comprising:

   - a step of measuring a residual capacity in a fully charged state for each of a plurality of batteries which are candidate batteries to constitute the serial body;
   - a step of selecting batteries constituting the serial body from among the plurality of candidate batteries on a basis of the residual capacities; and
   - a step of forming the serial body by only connecting the selected batteries in series,

   wherein the step of selecting the batteries includes selecting only the batteries wherein an absolute value of difference between the residual capacity of each battery and a maximum residual capacity among the batteries constituting the serial body is within 10 % of the maximum residual capacity.

2. An assembled battery manufacturing method using used batteries,
   wherein
   the assembled battery includes a parallel body constituted by parallel connection of a plurality of batteries,
   the assembled battery manufacturing method comprising:

   - a step of measuring an internal resistance and a remaining active material amount for each of a plurality of batteries which are candidate batteries to constitute the parallel body;
   - a step of calculating an evaluation value which is obtained by dividing a reciprocal of a value of the internal resistance by the remaining active material amount;
   - a step of selecting batteries constituting the parallel body from among the plurality of candidate batteries on a basis of the evaluation values; and
   - a step of forming the parallel body by only connecting the selected batteries in parallel,

   wherein the step of selecting the batteries includes selecting only the batteries wherein an absolute value of difference between the evaluation value of each battery and a maximum evaluation value among the batteries constituting the parallel body is within 10 % of the maximum evaluation value.

3. An assembled battery manufacturing method using used batteries, wherein the assembled battery includes a serial body constituted by series connection of a plurality of parallel bodies, each of the parallel bodies being constituted by parallel connection of a plurality of batteries, the assembled battery manufacturing method comprising:

   - a step of measuring a residual capacity in a fully charged state, an internal resistance, and a remaining active material amount for each of a plurality of batteries which are candidate batteries to constitute the assembled battery;
   - a step of calculating an evaluation value which is obtained by dividing a reciprocal of a value of the internal resistance by the remaining active material amount;
   - a step of selecting batteries constituting each of the parallel bodies from among the plurality of candidate batteries on a basis of the evaluation values, and forming each of the parallel bodies by only connecting the selected batteries in parallel; and
   - a step of selecting parallel bodies constituting the serial body from among the plurality of parallel bodies on a basis of the residual capacities, and forming the serial body by only connecting the selected parallel bodies in series,

   wherein the step of selecting the batteries constituting each of the parallel bodies includes selecting only the batteries wherein an absolute value of difference between the evaluation value of each battery and a maximum evaluation value among the batteries constituting each of the parallel bodies is within 10 % of the maximum evaluation value, and wherein the step of selecting the parallel bodies constituting the serial body includes selecting only the parallel bodies wherein an absolute value of difference between the residual capacity of each parallel body and a maximum residual capacity among the parallel bodies constituting the serial body is within 10 % of the maximum residual capacity.

4. The assembled battery manufacturing method according to claim 1 or 3, wherein the residual capacity is measured on a basis of a deformation amount which is obtained by detecting deformation of each of the batteries.

5. The assembled battery manufacturing method according to claim 2 or 3, wherein the remaining active material amount is measured on a basis of a deformation amount which is obtained by detecting deformation of each of the batteries.

6. The assembled battery manufacturing method according to claim 4 or 5, wherein means for detecting the deformation of each of the batteries includes a polymer matrix layer containing a magnetic filler and a detection unit that detects change in a magnetic field accompanying the deformation of the polymer matrix layer containing a magnetic filler.

7. An assembled battery using used batteries,
   wherein the assembled battery comprises a serial body constituted by series connection of a plurality of batteries, and
   wherein an absolute value of difference between a residual capacity in a fully charged state of each battery constituting the serial body and a maximum residual capacity among the batteries constituting the serial body is within 10 % of the maximum residual capacity.

8. An assembled battery using used batteries,
   wherein the assembled battery comprises a parallel body constituted by parallel connection of a plurality of batteries, and
   wherein an absolute value of difference between an evaluation value, which is obtained by dividing a reciprocal of an internal resistance value by a remaining active material amount, of each battery constituting the parallel body and a maximum evaluation value among the batteries constituting the parallel body is within 10 % of the maximum evaluation value.

9. An assembled battery using used batteries,
   wherein the assembled battery comprises a serial body constituted by series connection of a plurality of parallel bodies, each of the parallel bodies being constituted by parallel connection of a plurality of batteries, wherein an absolute value of difference between an evaluation value, which is obtained by dividing a reciprocal of an internal resistance value by a remaining active material amount, of each battery constituting each of the parallel bodies and a maximum evaluation value among the batteries constituting each of the parallel bodies is within 10 % of the maximum evaluation value, and
   wherein an absolute value of difference between a residual capacity in a fully charged state of each parallel body constituting the serial body and a maximum residual capacity among the parallel bodies constituting the serial body is within 10 % of the maximum residual capacity.

FIG. 1

POWER GENERATION DEVICE OR CHARGING DEVICE

SWITCHING CIRCUIT

CONTROLLING DEVICE

FIG. 2A

FIG. 2B

FIG. 3

FIG. 4

FIG. 5

```
┌─────────────────────────────────┐
│      ASSEMBLED BATTERY          │
│     MANUFACTURING METHOD        │
└─────────────────────────────────┘
              │
              ▼
┌─────────────────────────────────────────────────┐ ⟍ S11
│ MEASURE RESIDUAL CAPACITY IN FULLY CHARGED STATE │
│ FOR EACH OF A PLURALITY OF BATTERIES WHICH ARE   │
│ CANDIDATE BATTERIES TO CONSTITUTE SERIAL BODY    │
└─────────────────────────────────────────────────┘
              │
              ▼
┌─────────────────────────────────────────────────┐ ⟍ S12
│ SELECT BATTERIES (A, B) CONSTITUTING SERIAL BODY │
│ FROM AMONG A PLURALITY OF CANDIDATE BATTERIES    │
│ (A, B, C) ON BASIS OF RESIDUAL CAPACITIES, AND   │
│ HERE, SELECT ONLY BATTERIES (A, B) WHEREIN       │
│ ABSOLUTE VALUE OF DIFFERENCE BETWEEN RESIDUAL    │
│ CAPACITY OF EACH BATTERY AND MAXIMUM RESIDUAL    │
│ CAPACITY AMONG BATTERIES CONSTITUTING SERIAL     │
│ BODY IS WITHIN 10% OF MAXIMUM RESIDUAL CAPACITY  │
└─────────────────────────────────────────────────┘
              │
              ▼
┌─────────────────────────────────────────────────┐ ⟍ S13
│ FORM SERIAL BODY BY ONLY CONNECTING             │
│ SELECTED BATTERIES (A, B) IN SERIES             │
└─────────────────────────────────────────────────┘
              │
              ▼
          ┌────────┐
          │  END   │
          └────────┘
```

FIG. 6

```
┌─────────────────────────────────┐
│      ASSEMBLED BATTERY          │
│    MANUFACTURING METHOD         │
└─────────────────────────────────┘
                │
                ▼
┌─────────────────────────────────┐  S21
│ MEASURE INTERNAL RESISTANCE AND  │
│ REMAINING ACTIVE MATERIAL AMOUNT │
│ FOR EACH OF A PLURALITY OF       │
│ BATTERIES (A, B, C) WHICH ARE    │
│ CANDIDATE BATTERIES TO           │
│ CONSTITUTE PARALLEL BODY         │
└─────────────────────────────────┘
                │
                ▼
┌─────────────────────────────────┐  S22
│ CALCULATE EVALUATION VALUE WHICH │
│ IS OBTAINED BY DIVIDING          │
│ RECIPROCAL OF INTERNAL           │
│ RESISTANCE VALUE BY REMAINING    │
│ ACTIVE MATERIAL AMOUNT           │
└─────────────────────────────────┘
                │
                ▼
┌─────────────────────────────────┐  S23
│ SELECT BATTERIES (A, C)          │
│ CONSTITUTING PARALLEL BODY FROM  │
│ AMONG A PLURALITY OF CANDIDATE   │
│ BATTERIES (A, B, C) ON BASIS OF  │
│ EVALUATION VALUES, AND HERE,     │
│ SELECT ONLY BATTERIES (A, C)     │
│ WHEREIN ABSOLUTE VALUE OF        │
│ DIFFERENCE BETWEEN EVALUATION    │
│ VALUE OF EACH BATTERY AND        │
│ MAXIMUM EVALUATION VALUE AMONG   │
│ BATTERIES CONSTITUTING PARALLEL  │
│ BODY IS WITHIN 10% OF MAXIMUM    │
│ EVALUATION VALUE                 │
└─────────────────────────────────┘
                │
                ▼
┌─────────────────────────────────┐  S24
│ FORM PARALLEL BODY BY ONLY       │
│ CONNECTING SELECTED BATTERIES    │
│ (A, C) IN PARALLEL               │
└─────────────────────────────────┘
                │
                ▼
┌─────────────────────────────────┐
│              END                │
└─────────────────────────────────┘
```

FIG. 7

```
┌─────────────────────────────┐
│    ASSEMBLED BATTERY         │
│    MANUFACTURING METHOD      │
└─────────────────────────────┘
                │
                ▼
```
S31

MEASURE RESIDUAL CAPACITY IN FULLY CHARGED STATE, INTERNAL RESISTANCE, AND REMAINING ACTIVE MATERIAL AMOUNT FOR EACH OF A PLURALITY OF BATTERIES (A, B, B, C) WHICH ARE CANDIDATE BATTERIES TO CONSTITUTE ASSEMBLED BATTERY

S32

CALCULATE EVALUATION VALUE WHICH IS OBTAINED BY DIVIDING RECIPROCAL OF INTERNAL RESISTANCE VALUE BY REMAINING ACTIVE MATERIAL AMOUNT

S33

NEXT, SELECT BATTERIES [(A, C), (B, B)] CONSTITUTING PARALLEL BODIES FROM AMONG A PLURALITY OF CANDIDATE BATTERIES (A, B, B, C) ON BASIS OF EVALUATION VALUES, AND FORM PARALLEL BODIES [(A, C), (B, B)] BY ONLY CONNECTING SELECTED BATTERIES IN PARALLEL, AND HERE, SELECT ONLY BATTERIES [(A, C), (B, B)] WHEREIN ABSOLUTE VALUE OF DIFFERENCE BETWEEN EVALUATION VALUE OF EACH BATTERY AND MAXIMUM EVALUATION VALUE AMONG BATTERIES CONSTITUTING PARALLEL BODY IS WITHIN 10% OF MAXIMUM EVALUATION VALUE

S34

SELECT PARALLEL BODIES CONSTITUTING SERIAL BODY FROM AMONG A PLURALITY OF PARALLEL BODIES [(A, C), (B, B)] ON BASIS OF RESIDUAL CAPACITIES, AND FORM SERIAL BODY BY ONLY CONNECTING SELECTED PARALLEL BODIES IN SERIES, AND HERE, SELECT ONLY PARALLEL BODIES WHEREIN ABSOLUTE VALUE OF DIFFERENCE BETWEEN RESIDUAL CAPACITY OF EACH PARALLEL BODY AND MAXIMUM RESIDUAL CAPACITY AMONG PARALLEL BODIES [(A, C), (B, B)] CONSTITUTING SERIAL BODY IS WITHIN 10% OF MAXIMUM RESIDUAL CAPACITY

```
┌─────────────────────────────┐
│            END               │
└─────────────────────────────┘
```

## INTERNATIONAL SEARCH REPORT

| International application No. |
|---|
| PCT/JP2017/011176 |

A. CLASSIFICATION OF SUBJECT MATTER
*H01M2/10*(2006.01)i, *G01R31/36*(2006.01)i

According to International Patent Classification (IPC) or to both national classification and IPC

B. FIELDS SEARCHED

Minimum documentation searched (classification system followed by classification symbols)
H01M2/10, G01R31/36, H01M10/42-10/48, H01M10/52-10/667

Documentation searched other than minimum documentation to the extent that such documents are included in the fields searched
Jitsuyo Shinan Koho          1922–1996   Jitsuyo Shinan Toroku Koho   1996–2017
Kokai Jitsuyo Shinan Koho    1971–2017   Toroku Jitsuyo Shinan Koho   1994–2017

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2008-293703 A  (Panasonic EV Energy Co., Ltd.), 04 December 2008 (04.12.2008), & US 2010/0047684 A1 | 1-9 |
| A | JP 2015-103387 A  (Primearth EV Energy Co., Ltd.), 04 June 2015 (04.06.2015), & US 2015/0145521 A1 | 1-9 |
| A | JP 2005-238969 A  (Mitsubishi Heavy Industries, Ltd.), 08 September 2005 (08.09.2005), (Family: none) | 1-9 |

☒   Further documents are listed in the continuation of Box C.       ☐   See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 06 June 2017 (06.06.17) | 20 June 2017 (20.06.17) |

| Name and mailing address of the ISA/ | Authorized officer |
|---|---|
| Japan Patent Office 3-4-3,Kasumigaseki,Chiyoda-ku, Tokyo 100-8915,Japan | Telephone No. |

Form PCT/ISA/210 (second sheet) (January 2015)

**INTERNATIONAL SEARCH REPORT**

| International application No. |
| --- |
| PCT/JP2017/011176 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | WO 2011/162014 A1  (Toyota Motor Corp.),<br>29 December 2011 (29.12.2011),<br>& US 2013/0090872 A1 | 1-9 |
| A | JP 2014-020818 A  (Toyota Motor Corp.),<br>03 February 2014 (03.02.2014),<br>& US 2014/0015537 A1 | 1-9 |
| A | JP 2014-011060 A  (Sanyo Electric Co., Ltd.),<br>20 January 2014 (20.01.2014),<br>(Family: none) | 1-9 |
| A | JP 2014-221002 A  (Panasonic Corp.),<br>20 November 2014 (20.11.2014),<br>& US 2016/0006085 A1 | 1-9 |
| A | WO 2011/121755 A1  (Toyota Motor Corp.),<br>06 October 2011 (06.10.2011),<br>& US 2013/0015702 A1    & EP 2555311 A1 | 1-9 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2015103387 A

- JP 2005238969 A